# EUROPÄISCHE PATENTANMELDUNG

(11) **EP 0 601 595 A1**
(43) Veröffentlichungstag der Anmeldung: **15.06.1994**
(21) Anmeldenummer: 93119967.3
(22) Anmeldetag: 10.12.1993
(51) Int. Cl.: H05H 1/18, H05H 1/46, H01J 37/32

(54) **Zur Anordnung in einem Vakuumgefäss geeignete selbsttragende isolierte Leiteranordnung, insbesondere Antennenspule für einen Hochfrequenz-Plasmagenerator**

(30) Priorität: 11.12.1992 DE 4241927
(71) Anmelder: Max-Planck-Gesellschaft zur Förderung der Wissenschaften e.V. Berlin, D-80539 München (DE)
(72) Erfinder: Kraus, Werner, Dipl.-Phys., D-85748 Garching (DE)
(74) Vertreter: von Bezold, Dieter, Dr.

(57) **Zusammenfassung**

Eine zur Anordnung in einem Vakuumgefäß geeignete selbsttragende elektrische Leiteranordnung, insbesondere Spule, enthält als tragende Struktur ein Rohr (18a) aus Isoliermaterial, z.B. Quarzglas, in dem ein elektrischer Leiter (18b) in Form einer Drahtlitze oder einer auf der Innenwand des Rohres niedergeschlagenen elektrisch leitenden Schicht angeordnet ist. Ein bevorzugtes Anwendungsgebiet ist eine im Plasma liegende spulenförmige isolierte Antenne für einen Hochfrequenz-Plasmagenerator.

## Beschreibung

Die vorliegende Erfindung betrifft eine selbsttragende isolierte Leiteranordnung, die sich für die Anordnung in einem Vakuumgefäß und insbesondere als im Plasma liegende isolierte Antenne für einen Hochfrequenz-Plasmagenerator eignet. Der Begriff "Leiteranordnung" soll auch elektrische Spulen, Elektroden u.a.m. umfassen.

Bei Hochfrequenz-Ionenquellen gemäß dem Stand der Technik, bei denen eine Plasmaentladung in einem mit Gas unter vermindertem Druck gefüllten Entladungsgefäß durch eine mit Hochfrequenz gespeiste elektrische Spule erzeugt wird, kann sich die als Hochfrequenzantenne dienende Spule entweder außerhalb oder innerhalb des Entladungsgefäßes befinden.

Im ersteren Falle müssen die Wände des Entladungsgefäßes aus Isoliermaterial, z.B. Quarzglas, bestehen, damit die Hochfrequenz-Leistung in das Entladungsvolumen eingekoppelt werden kann und Wirbelstromverluste in den Wänden vermieden werden. Große Entladungsgefäße, insbesondere solche mit nicht kreisförmigem Querschnitt müssen meist in einem Vakuumtank angeordnet werden, um eine übermäßige Belastung der Wand des Entladungsgefäßes durch den Luftdruck zu vermeiden.

Im zweiten Fall besteht das Problem darin, die Windungen der die Hochfrequenzantenne bildenden Spule, die selbsttragend sein muß, ausreichend gegen das erzeugte Plasma zu isolieren, um Bogenentladungen zwischen den Windungen, den Anschlüssen der Spule und an den Durchführungen durch die Wand des Entladungsgefäßes zu verhindern, da solche Bogenentladungen zu einer Verunreinigung des Plasmas und zur Zerstörung der Spule führen. Die Isolation muß den chemisch aggressiven Plasmaspezies und der hohen thermischen Belastung durch das Plasma standhalten können. Es darf nicht zur Rißbildung oder zum Abplatzen kommen, was leicht eintritt, wenn die thermischen Ausdehnungskoeffizienten und die Elastizität des Spulenleiters und der Isolation nennenswert voneinander abweichen.

Es ist bekannt, wassergekühlte Spulen aus Metallrohr, im allgemeinen aus Kupfer, zu verwenden, die mit mehreren Lagen Glasfaser- bzw. Quarzfasergeflecht und Schrumpfschläuchen oder durch Emaillieren isoliert sind. Eine Lösung, die auch für längere Betriebszeiten geeignet ist, was bei leistungsstärkeren Plasmageneratoren für die Kernfusionstechnik u. dgl. mehr als etwa 5 Sekunden bedeutet, wurde noch nicht gefunden. Die elektrische Isolation hält im allgemeinen nur kurze Pulse aus, ein weiterer Nachteil besteht darin, daß zwischen dem gekühlten, rohrförmigen Spulenleiter und der Isolation fast kein thermischer Kontakt besteht und ferner, daß die Oberfläche und dadurch die Ausgasrate sowie die Errosionsfläche sehr groß sind.

Der vorliegenden Erfindung liegt dementsprechend die Aufgabe zugrunde, eine selbsttragende, elekrisch isolierte Spule oder andere Leiter- oder Elektrodenanordnung anzugeben, die sich für die Anordnung in einem Vakuumgefäß eignet und hohen thermischen Belastungen sowie Beanspruchungen durch ein umgebendes Plasma gut standzuhalten vermag.

Gemäß der vorliegenden Erfindung ist eine zur Anordnung in einem Vakuumgefäß geeignete, selbsttragende isolierte elektrische Leiteranordnung, z. B. in Form einer Spule oder einer kapazitiven Elektrode, mit einem elektrischen Leiter und einer diesen umgebenden Isolierung dadurch gekennzeichnet, daß die Isolierung aus einer Rohrstruktur aus Isoliermaterial, wie Quarzglas, besteht, die die tragende Struktur der Leiteranordnung darstellt und den elektrischen Leiter enthält.

Der Leiter kann beispielsweise die Form einer Litze oder eines auf der Innenseite des Rohres niedergeschlagenen elektrisch leitfähigen Belages haben.

Gegenüber den bisherigen isolierten Leiteranordnungen hat der Erfindungsgegenstand eine Reihe von Vorteilen, insbesondere eine bessere und widerstandsfähigere elektrische Isolation; das Fehlen von mechanischen Spannungen zwischen dem elektrischen Leiter und der Isolation; die Möglichkeit der direkten Kühlung der Isolation und des Leiters durch Hindurchleiten von Gas oder Flüssigkeit durch die Rohrstruktur, deren Querschnitt nicht völlig vom Leiter ausgefüllt wird. Hierdurch ergeben sich bessere thermische Eigenschaften insbesondere bei länger dauerndem Betrieb. Im Vergleich zu einer außerhalb des Entladungsgefäßes angeordneten Spule sind der apparative Aufwand sowie der Raumbedarf kleiner und die Wand des Entladungsgefäßes ist hinsichtlich Material und Formgebung keinen Einschränkungen unterworfen. Das Innere des tragenden Isolierrohres kann unter Atmosphärendruck oder sogar Überdruck stehen.

Bevorzugte Anwendungsgebiete der Erfindung sind Hochfrequenzantennen für Hochfrequenz-Plasmageneratoren in der Plasmatechnologie, Hochleistungs-Hochfrequenz-Ionenquellen für die Erzeugung von positiven oder negativen Ionen sowie Hochfrequenz-Plasma-Neutralisatoren für die Neutralinjektion in Kernfusionsanlagen.

Im folgenden wird die Erfindung anhand eines Ausführungsbeispieles unter Bezugnahme auf die Zeichnung näher erläutert, deren einzige Figur eine Entladungskammeranordnung eines Hochfrequenz-Plasmagenerators im Schnitt zeigt, welche eine isolierte spulenförmige Hochfrequenzantenne gemäß einer Ausführungsform der Erfindung enthält.

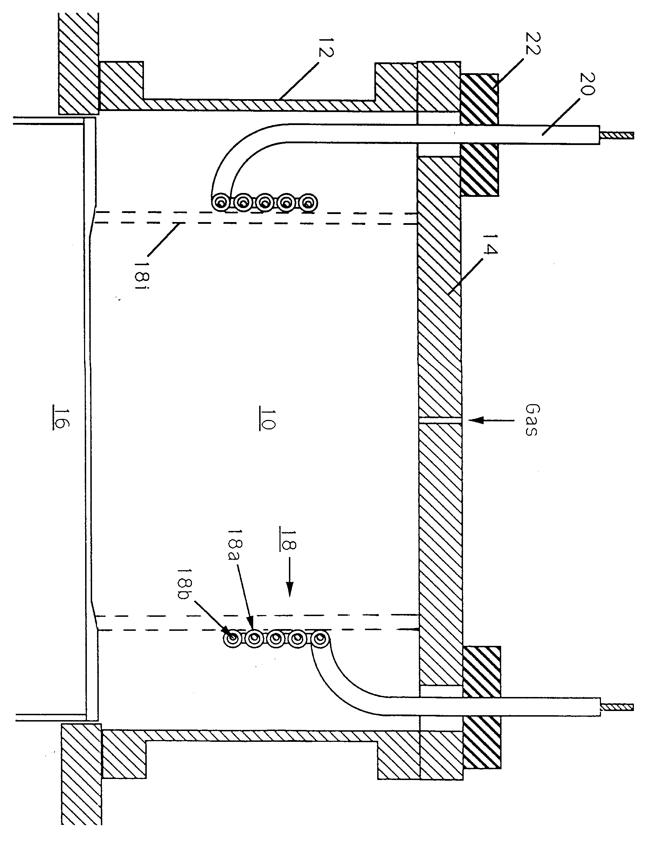

Die in Fig. 1 dargestellte Entladungskammeranordnung weist einen Entladungsraum 10 auf, der durch eine metallische Seitenwand 12 und einen Deckel 14 begrenzt ist. An der dem Deckel 14 entgegengesetzten Seite ist der Entladungsraum zu einem Beschleunigungssystem 16 hin offen. Im Entladungsraum 10 ist eine Hochfrequenzantenne in Form einer einlagigen, isolierten Spule 18 angeordnet. Die Spule ist über Zuleitungen 20 mit einem nicht dargestellten Hochfrequenzgenerator verbunden. In der Praxis ist an das Beschleunigungssystem 16 außerdem ein Vakuumsystem (nicht dargestellt) angeschlossen. Der Deckel 14 ist ferner mit einer nur schematisch angedeuteten Anordnung zum Einführen von Gas, das durch das von der Hochfrequenzantenne erzeugte Feld ionisiert wird, versehen.

Ein wesentliches Problem bei einer Anordnung dieser Art besteht, wie bereits erwähnt wurde, darin, die Spule 18 mit einer Isolierung zu versehen, die der thermischen Belastung durch das Plasma und dem chemischen Angriff der Ionen und Neutralteilchen des Plasmas zu widerstehen vermag. Man hat bisher, wie erwähnt, wassergekühlte Spulen aus Kupferrohr verwendet, die mit mehreren Lagen Glasfaser- bzw. Quarzgeflecht und Schrumpfschläuchen oder durch eine Emaillierung isoliert waren. Diese bekannten Isolierungen haben sich jedoch als unbrauchbar erwiesen. Man hat daher auch, wie gestrichelt angedeutet, die Spule außerhalb des Entladungsraumes angeordnet und dessen Seitenwand 18i aus Isoliermaterial, wie Quarzglas, hergestellt. Da der Entladungsraum im allgemeinen nicht zylindrisch sondern langgestreckt ist, besteht hier die Gefahr, daß die aus Isoliermaterial bestehende Seitenwand 18i des Entladungsraumes dem Atmosphärendruck nicht standhält. Man mußte daher einen zusätzlichen Vakuumtank vorsehen, um die Isoliermaterialwand 18i vom Atmosphärendruck zu entlasten. Es ist einleuchtend, daß hierdurch entweder die Gesamtabmessungen vergrößert oder der Entladungsraum verkleinert werden müssen.

Die vorliegende Erfindung ermöglicht es, die Probleme hinsichtlich der Beständigkeit der Isolierung einer in einem Plasmaentladungsraum angeordneten Spule oder anderen Elektrodenanordnung zu lösen, sodaß die Wand des Entladungsgefäßes aus beliebigem, mechanisch widerstandsfähigen Material, wie Metall, hergestellt werden kann und kein zusätzlicher, platzraubender Vakuumtank zur Druckentlastung benötigt wird.

Die Lösung des Problems besteht darin, daß nicht ein Metallrohr als tragende Struktur der Spule (oder anderen Elektrodenanordnung) dient, wie es bisher bei im Entladungsraum angeordneter Spule der Fall war, sondern ein die Spulenisolation bildendes Rohr 18a aus einem geeigneten Isoliermaterial, z.B. Quarzglas. Da Rohre schon aufgrund ihrer Konfiguration eine hohe Druckfestigkeit aufweisen und Isoliermaterialien mit hoher Druckfestigkeit, wie Quarzglas, Hartglas, Oxydkeramik sowie verschiedene andere Arten von Keramik zur Verfügung stehen, kann das Isolierrohr 18a eine relativ geringe Wandstärke haben.

Der die eigentliche Spule bildende elektrische Leiter 18b befindet sich innerhalb des Isolierrohrs 18b und kann aus einer Metalldrahtlitze oder einem auf der Innenwand des Isolierrohres 18a z.B. elektrochemisch abgeschiedenen leitfähigen Belages bestehen.

Die Zuleitungen 20 der Spule 18 sind durch Durchführungen 22 aus dem Entladungsraum herausgeführt. Da der Spulenleiter durch das Isolierrohr isoliert ist, brauchen die Durchführungen keine elektrische Isolation enthalten.

Bei der dargestellten Ausführungsform sind benachbarte Rohrwindungen miteinander verbunden, z. B. verschmolzen, um die mechanische Stabilität zu erhöhen.

Wenn der Leiter 18b den Querschnitt des Rohres 18a nicht vollständig ausfüllt, was im allgemeinen der Fall sein wird, können das Isolierrohr und der Leiter durch ein durch das Rohr geleitetes Kühlfluid direkt gekühlt werden.

Die vorliegende Erfindung ist nicht auf das beschriebene Ausführungsbeispiel beschränkt, es können vielmehr auch andere selbsttragende Leiter- und Elektrodenstrukturen in der erfindungsgemäßen Weise ausgebildet werden, z.B. Spulen anderer Konfiguration oder auch z. B. kammförmige oder schlangenlinienförmige oder rostförmige kapazitive Elektroden ("Elektrodenplatten").

## Patentansprüche

1. Zur Anordnung in einem Vakuumgefäß geeignete selbsttragende isolierte elektrische Leiteranordnung mit einem elektrischen Leiter und einer diesen umgebenden Isolierung, **dadurch gekennzeichnet**, daß die Isolierung aus einer Rohrstruktur (18a) aus Isoliermaterial besteht, die die tragende Struktur der Leiteranordnung darstellt und den elektrischen Leiter (18b) enthält.

2. Leiteranordnung nach Anspruch 1, **dadurch gekennzeichnet**, daß die tragende Rohrstruktur (18a) und der in ihr angeordnete elektrische Leiter (18b) die Form einer Spule haben.

3. Leiteranordnung nach Anspruch 1, **dadurch gekennzeichnet**, daß die Rohrstruktur eine schlangenlinienförmige oder kammförmige oder rostförmige Konfiguration hat.

4. Leiteranordnung nach einem der vorhergehenden Ansprüche, **dadurch gekennzeichnet**, daß die Rohrstruktur aus Glas, insbesondere Quarzglas, besteht.

5. Leiteranordnung nach einem der vorhergehenden Ansprüche, **gekennzeichnet durch** eine Vorrichtung (26) zum Hindurchleiten eines Kühlfluids durch die Rohrstruktur (18a).

6. Hochfrequenzantenne eines Hochfrequenz-Plasmagenerators, **gekennzeichnet durch** eine Leiteranordnung gemäß einem der vorhergehenden Ansprüche.
